# EUROPEAN PATENT APPLICATION

(11) **EP 4 455 152 A1**
(43) Date of publication of application: **30.10.2024**
(21) Application number: 22925103.8
(22) Date of filing: 01.12.2022
(51) Int. Cl.: C07F 7/22, C07F 1/00, C01G 30/00, H01L 29/786, H01L 29/66, H10K 10/00, H01L 29/24

(54) **PEROVSKITE COMPOSITE COMPRISING ANTIMONY TRIFLUORIDE, ELECTRONIC ELEMENT COMPRISING SAME, AND PREPARATION METHOD THEREFOR**

(30) Priority: 04.02.2022 KR 20220014547; 01.09.2022 KR 20220110804
(71) Applicant: POSTECH Research and Business Development Foundation, Pohang-si, Gyeongsangbuk-do 37673 (KR)
(72) Inventor: NOH, Yong-Young, Pohang-si Gyeongsangbuk-do 37673 (KR); LIU, Ao, Pohang-si Gyeongsangbuk-do 37673 (KR)
(74) Representative: Stolmár & Partner Patentanwälte PartG mbB
(86) International application number: PCT/KR2022/019319
(87) International publication number: WO 2023/149636

(57) **Abstract**

A perovskite composite comprising antimony trifluoride, an electronic element comprising same, and a preparation method therefor are disclosed. The perovskite composite comprises tin (Sn)-based perovskite and antimony trifluoride (SbF₃) so that lead (Pb) is not added thereto, and has a low hole concentration (≤ 10¹⁴ cm⁻¹), and thus can be used for an optoelectronic device.

## Description

### Technical Field

The present disclosure relates to a perovskite composite containing antimony trifluoride, an electronic element including the same, and a preparation method thereof.

### Background Art

Metal halide perovskite materials are used in optoelectronic devices to make the use of such optoelectronic devices efficient and stable. However, most perovskite optoelectronic devices are based on lead (Pb), and the commercial application thereof to various fields is challenging due to Pb toxicity and environmental hazards. Accordingly, there is a need to develop Pb-free perovskite materials to maintain improved optoelectronic device performance while avoiding environmental hazards.

Research has been conducted on tin halide perovskite as a Pb-free perovskite material. However, tin (Sn) is easily oxidized and may form undesirable electron traps. Additionally, the excessive hole concentration (> 10¹⁸ cm⁻³) results in high p-type conductivity, making tin halide perovskite unsuitable to be used as a functional material for optoelectronic devices, which is problematic.

### Disclosure

### Technical Problem

The present disclosure, which has been proposed to solve the problems described above, aims to provide a tin-based perovskite composite having a low hole concentration (≤ 10¹⁴ cm⁻¹) and thus being usable for an optoelectronic device.

Additionally, the present disclosure aims to provide an optoelectronic device (for example, a transistor, a solar cell, a light-emitting diode, and the like) including the tin-based perovskite composite and thus having high stability.

### Technical Solution

According to a first aspect of the present disclosure, provided is a perovskite composite containing a tin (Sn)-based perovskite and antimony trifluoride (SbF₃).

Additionally, the Sn-based perovskite may be doped with the SbF₃.

Additionally, the Sn-based perovskite may be represented by Structural Formula 1 below.

[Structural Formula 1] A₍₁₋ₐ₎ (B_{(1-b)}C_{b})ₐSn(X_{(1-c)}Y_{c})₃

In Structural Formula 1,
A is cesium (Cs),
B and C are different from each other and are each independently methylammonium (MA) or formamidinium (FA),
a is a real number of 0 ≤ a ≤ 1,
b is a real number of 0 ≤ b ≤ 1,
X and Y are different from each other and are each independently fluorine (F), chlorine (Cl), bromine (Br), or iodine (I), and
c is a real number of 0 ≤ c ≤ 1.

Additionally, the perovskite composite may contain 0.01 to 50 mol of the SbF₃ based on 100 mol of the Sn-based perovskite.

Additionally, the perovskite composite may further contain tin fluoride (SnF₂), and the Sn-based perovskite may be co-doped with the SbF₃ and the SnF₂.

Additionally, the perovskite composite may contain 0.01 to 50 mol of the SnF₂ based on 100 mol of the Sn-based perovskite.

According to a second aspect of the present disclosure, provided is any one electronic element selected from the group consisting of a transistor, a solar cell, a light-emitting diode, a photodiode, and a photosensor, the electronic element including the perovskite composite.

According to a third aspect of the present disclosure, provided is a perovskite transistor including a gate electrode, an insulating layer disposed on the gate electrode, an active layer disposed on the insulating layer, the active layer including a perovskite composite containing a tin (Sn)-based perovskite and antimony trifluoride (SbF₃), and a source electrode and a drain electrode spaced from each other while being disposed on the active layer.

Additionally, the Sn-based perovskite may be doped with the SbF₃.

Additionally, the Sn-based perovskite may be represented by Structural Formula 1 below.

[Structural Formula 1] A₍₁₋ₐ₎(B_{(1-b)}C_{b})ₐSn(X_{(1-c)}Y_{c})₃

In Structural Formula 1,
A is cesium (Cs),
B and C are different from each other and are each independently methylammonium (MA) or formamidinium (FA),
a is a real number of 0 ≤ a ≤ 1,
b is a real number of 0 ≤ b ≤ 1,
X and Y are different from each other and are each independently fluorine (F), chlorine (Cl), bromine (Br), or iodine (I), and
c is a real number of 0 ≤ c ≤ 1.

Additionally, the perovskite composite may contain 0.01 to 50 mol of the SbF₃ based on 100 mol of the Sn-based perovskite.

Additionally, the perovskite composite may further contain tin fluoride (SnF₂), and the Sn-based perovskite may be co-doped with the SbF₃ and the SnF₂.

Additionally, the perovskite composite may contain 0.01 to 50 mol of the SnF₂ based on 100 mol of the Sn-based perovskite.

Additionally, the gate electrode may include one or more selected from the group consisting of n-doped silicon (Si), p-doped Si, gold (Au), silver (Ag), platinum (Pt), titanium (Ti), Aluminum (Al), tungsten (W), magnesium (Mg), calcium (Ca), ytterbium (Yb), chromium (Cr), nickel (Ni), gold oxide, platinum oxide, silver oxide, palladium oxide, iron oxide, graphene, a carbon nanotube (CNT), an Ag nanowire (NW), indium tin oxide, and poly(3,4-ethylenedioxythiophene) polystyrene sulfonate (PEDOT:PSS), and the source electrode and the drain electrode may each independently include one or more selected from the group consisting of Au, Ag, Pt, Ti, Al, W, Mg, Ca, Yb, Cr, Ni, gold oxide, platinum oxide, silver oxide, palladium oxide, iron oxide, graphene, a CNT, an Ag NW, indium tin oxide, and PEDOT:PSS.

Additionally, the insulating layer may include one or more selected from the group consisting of silicon dioxide, glass, quartz, alumina, silicon carbide, magnesium oxide, polyethylene naphthalate (PEN), polyethylene terephthalate (PET), polystyrene (PS), polyimide (PI), polyvinyl chloride (PVC), polyvinylpyrrolidone (PVP), polyethylene (PE), silicon oxide (SiO₂), germanium, polyvinyl alcohol (PVA), polymethyl methacrylate (PMMA), zirconium oxide (ZrO₂), aluminum oxide (AlO₂), and hafnium oxide (HfO₂).

According to a fourth aspect of the present disclosure, provided is a method of preparing a perovskite composite, the method including the following steps: (a) preparing a mixed solution by mixing antimony trifluoride (SbF₃) in a solution containing a compound represented by Structural Formula 2 below and a tin halide represented by Structural Formula 3 below, (b) preparing a perovskite precursor solution by heating the mixed solution, and (c) preparing a perovskite composite containing a tin (Sn)-based perovskite and the SbF₃ by drying the perovskite precursor solution and then subjecting the dried perovskite precursor solution to heat treatment.

[Structural Formula 2] A₍₁₋ₐ₎(B_{(1-b)}C_{b})ₐ(X_{(1-c)}Y_{c})₁

[Structural Formula 3] Sn(X_{(1-c)}Y_{c})₂

In Structural Formulas 2 and 3,
A is cesium (Cs),
B and C are different from each other and are each independently methylammonium (MA) or formamidinium (FA),
a is a real number of 0 ≤ a ≤ 1,
b is a real number of 0 ≤ b ≤ 1,
X and Y are different from each other and are each independently fluorine (F), chlorine (Cl), bromine (Br), or iodine (I), and
c is a real number of 0 ≤ c ≤ 1.

Additionally, the Sn-based perovskite may be doped with the SbF₃.

Additionally, the perovskite may be represented by Structural Formula 1 below.

[Structural Formula 1] A₍₁₋ₐ₎(B_{(1-b)}C_{b})ₐSn(X_{(1-c)}Y_{c})₃

In Structural Formula 1,
A is cesium (Cs),
B and C are different from each other and are each independently methylammonium (MA) or formamidinium (FA),
a is a real number of 0 ≤ a ≤ 1,
b is a real number of 0 ≤ b ≤ 1,
X and Y are different from each other and are each independently fluorine (F), chlorine (Cl), bromine (Br), or iodine (I), and
c is a real number of 0 ≤ c ≤ 1.

Additionally, the mixed solution may contain 0.01 to 50 mol of the SbF₃ based on 100 mol of the Sn in the tin halide.

Additionally, the perovskite composite may further contain tin fluoride (SnF₂), and the Sn-based perovskite may be co-doped with the SbF₃ and the SnF₂.

Additionally, the mixed solution may contain 0.01 to 50 mol of the SnF₂ based on 100 mol of the Sn in the tin halide.

Additionally, Step (b) may be performed at a temperature in the range of 80°C to 150°C.

Additionally, Step (c) may be performed at a temperature in the range of 100°C to 150°C.

According to a fifth aspect of the present disclosure, provided is a method of manufacturing a perovskite transistor, the method including the following steps: (1) preparing a gate electrode/insulating layer stack including a gate electrode and an insulating layer disposed on the gate electrode, (2) forming an active layer including a perovskite composite containing a tin (Sn)-based perovskite and antimony trifluoride (SbF₃) on the insulating layer, and (3) forming a source electrode and a drain electrode on the active layer.

### Advantageous Effects

A perovskite composite of the present disclosure is lead (Pb)-free by containing a tin (Sn)-based perovskite and antimony trifluoride (SbF₃), has a low hole concentration (≤ 10¹⁴ cm⁻¹) , and thus can be used for an optoelectronic device.

Additionally, a perovskite transistor of the present disclosure includes the perovskite composite and thus can be highly stable.

### Description of Drawings

These drawings are for the purpose of describing exemplary embodiments of the present disclosure, and the technical idea of the present disclosure thus should not be construed as being limited to the accompanying drawings:
FIG. 1 shows images of a precursor solution (left) prepared in Example 1-3 and a precursor solution (right) prepared in Comparative Example 1-3;
FIG. 2 shows measurement results of hole concentration in perovskite composites of Examples 1-1 to 1-3 and Comparative Examples 1-1 to 1-4;
FIG. 3 shows scanning electron microscope (SEM) images of perovskite composites of Example 1-3 and Comparative Examples 1-3 and 1-4;
FIG. 4A shows a schematic diagram of a perovskite transistor according to one embodiment of the present disclosure;
FIG. 4B shows a schematic diagram of a perovskite transistor including a perovskite composite containing tin fluoride (SnF₂) instead of antimony trifluoride (SbF₃) in an active layer;
FIG. 5A shows a transfer curve for perovskite transistors according to Device Examples 1 to 3 and Device Comparative Example 1;
FIG. 5B shows an output curve for a perovskite transistor according to Device Example 2;
FIG. 6A shows a transfer curve for perovskite transistors according to Device Comparative Examples 1 to 4;
FIG. 6B shows an output curve for a perovskite transistor according to Device Comparative Example 2;
FIG. 7 shows confirmation results of operational stability in Device Example 2 and Device Comparative Example 2;
FIG. 8A shows a transfer curve for perovskite transistors according to Device Examples 3 and 4 and Device Comparative Example 3;
FIG. 8B shows an output curve for a perovskite transistor according to Device Example 4; and
FIG. 9 shows confirmation results of operational stability in Device Example 4 and Device Comparative Example 3.

### Best Mode

Hereinafter, embodiments of the present disclosure will be described in detail with reference to the accompanying drawings so that those skilled in the art can easily carry out the present disclosure.

However, the following description does not limit the present disclosure to specific embodiments. In the following description of the present disclosure, the detailed description of related arts will be omitted if it is determined that the gist of the present disclosure may be blurred.

Terms used herein are used only to describe specific embodiments and are not intended to limit the present disclosure. The singular expression includes the plural expression unless the context clearly indicates otherwise. It will be further understood that the terms "comprises", "includes", or "has" when used herein specify the presence of stated features, regions, integers, steps, operations, elements, and/or components, but do not preclude the presence or addition of one or more other features, regions, integers, steps, operations, elements, components, and/or combinations thereof.

Additionally, terms, such as "first", "second", etc. used herein, may be used to describe various components, but the components are not to be construed as being limited to the terms. These terms are used only for the purpose of distinguishing one component from another component. For example, without departing from the scope of the present disclosure, a first component may be referred to as a second component, and a second component may be also referred to as a first component.

Additionally, when a component is referred to as being "formed" or "laminated" on another component, it may be formed directly or attached to the front or one surface on the surface of the other component, but it will be understood that intervening elements may be present therebetween.

Hereinafter, a perovskite composite including antimony trifluoride, an electronic element including the same, and a preparation method thereof will be described in detail. However, these are disclosed only for illustrative purposes and are not meant to limit the present disclosure, and the scope of the present disclosure is only defined by the appended claims.

The present disclosure provides a perovskite composite containing a tin (Sn)-based perovskite and antimony trifluoride (SbF₃).

Additionally, the Sn-based perovskite may be doped with the SbF₃.

Additionally, the Sn-based perovskite may be represented by Structural Formula 1 below.

[Structural Formula 1] A₍₁₋ₐ₎(B_{(1-b)}C_{b})ₐSn(X_{(1-c)}Y_{c})₃

In Structural Formula 1,
A is cesium (Cs),
B and C are different from each other and are each independently methylammonium (MA) or formamidinium (FA),
a is a real number of 0 ≤ a ≤ 1,
b is a real number of 0 ≤ b ≤ 1,
X and Y are different from each other and are each independently fluorine (F), chlorine (Cl), bromine (Br), or iodine (I), and
c is a real number of 0 ≤ c ≤ 1.

Additionally, the perovskite composite may contain 0.01 to 50 mol of the SbF₃, which is preferably in the range of 0.1 to 10 mol and more preferably in the range of 0.1 to 5 mol, based on 100 mol of the tin-based perovskite. When the amount of the SbF₃ is less than 0.01 mol, an effect in hole concentration reduction obtained by containing SbF₃ is insignificant, which is undesirable. When the amount of the SbF₃ exceeds 50 mol, the effect is insignificant compared to the amount of SbF₃ used, which is economically undesirable.

Additionally, the perovskite composite may further contain tin fluoride (SnF₂), and the Sn-based perovskite may be co-doped with the SbF₃ and the SnF₂.

Additionally, the perovskite composite may contain 0.01 to 50 mol of the SnF₂, which is preferably in the range of 0.1 to 10 mol and more preferably in the range of 0.1 to 5 mol, based on 100 mol of the Sn-based perovskite. When the amount of the SnF₂ is less than 0.01 mol, an effect in hole concentration reduction obtained by containing SnF₂ is insignificant, which is undesirable. When the amount of the SnF₂ exceeds 50 mol, phase separation occurs due to the aggregation of SnF₂, which is undesirable.

The present disclosure provides any one electronic element selected from the group consisting of a transistor, a solar cell, a light-emitting diode, a photodiode, and a photosensor, the electronic element including the perovskite composite.

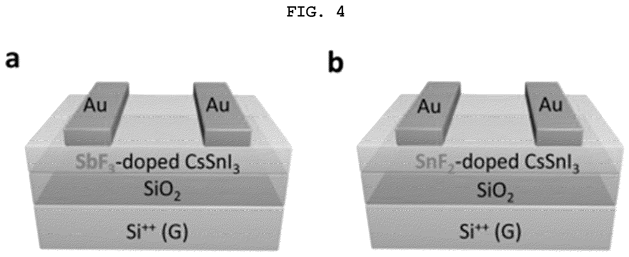

FIG. 4A shows the schematic diagram of a perovskite transistor according to one embodiment of the present disclosure.

Referring to 4A, the present disclosure provides a perovskite transistor including a gate electrode, an insulating layer disposed on the gate electrode, an active layer disposed on the insulating layer, the active layer including a perovskite composite containing a tin (Sn)-based perovskite and antimony trifluoride (SbF₃), and a source electrode and a drain electrode spaced from each other while being disposed on the active layer.

Additionally, the Sn-based perovskite may be represented by Structural Formula 1 below.

[Structural Formula 1] A₍₁₋ₐ₎(B_{(1-b)}C_{b})ₐSn(X_{(1-c)}Y_{c})₃

In Structural Formula 1,
A is cesium (Cs),
B and C are different from each other and are each independently methylammonium (MA) or formamidinium (FA),
a is a real number of 0 ≤ a ≤ 1,
b is a real number of 0 ≤ b ≤ 1,
X and Y are different from each other and are each independently fluorine (F), chlorine (Cl), bromine (Br), or iodine (I), and
c is a real number of 0 ≤ c ≤ 1.

Additionally, the perovskite composite may contain 0.01 to 50 mol of the SbF₃, which is preferably in the range of 0.1 to 10 mol and more preferably in the range of 0.1 to 5 mol, based on 100 mol of the tin-based perovskite. When the amount of the SbF₃ is less than 0.01 mol, an effect in hole concentration reduction obtained by containing SbF₃ is insignificant, which is undesirable. When the amount of the SbF₃ exceeds 50 mol, the effect is insignificant compared to the amount of SbF₃ used, which is economically undesirable.

Additionally, the perovskite composite may further contain tin fluoride (SnF₂), and the tin-based perovskite may be co-doped with the SbF₃ and the SnF₂.

Additionally, the perovskite composite may contain 0.01 to 50 mol of the SnF₂, which is preferably in the range of 0.1 to 10 mol and more preferably in the range of 0.1 to 5 mol, based on 100 mol of the Sn-based perovskite. When the amount of the SnF₂ is less than 0.01 mol, an effect in hole concentration reduction obtained by containing SnF₂ is insignificant, which is undesirable. When the amount of the SnF₂ exceeds 50 mol, phase separation occurs due to the aggregation of SnF₂, which is undesirable.

Additionally, the gate electrode may include one or more selected from the group consisting of n-doped silicon (Si), p-doped Si, gold (Au), silver (Ag), platinum (Pt), titanium (Ti), Aluminum (Al), tungsten (W), magnesium (Mg), calcium (Ca), ytterbium (Yb), chromium (Cr), nickel (Ni), gold oxide, platinum oxide, silver oxide, palladium oxide, iron oxide, graphene, a carbon nanotube (CNT), an Ag nanowire (NW), indium tin oxide, and poly(3,4-ethylenedioxythiophene) polystyrene sulfonate (PEDOT:PSS) .

Specifically, the source electrode and the drain electrode may each independently include one or more selected from the group consisting of Au, Ag, Pt, Ti, Al, W, Mg, Ca, Yb, Cr, Ni, gold oxide, platinum oxide, silver oxide, palladium oxide, iron oxide, graphene, a CNT, an Ag NW, indium tin oxide, and PEDOT:PSS.

Additionally, the insulating layer may include one or more selected from the group consisting of silicon dioxide, glass, quartz, alumina, silicon carbide, magnesium oxide, polyethylene naphthalate (PEN), polyethylene terephthalate (PET), polystyrene (PS), polyimide (PI), polyvinyl chloride (PVC), polyvinylpyrrolidone (PVP), polyethylene (PE), silicon oxide (SiO₂), germanium, polyvinyl alcohol (PVA), polymethyl methacrylate (PMMA), zirconium oxide (ZrO₂), aluminum oxide (AlO₂), and hafnium oxide (HfO₂).

The present disclosure provides a method of preparing a perovskite composite, the method including the following steps: (a) preparing a mixed solution by mixing antimony trifluoride (SbF₃) in a solution containing a compound represented by Structural Formula 2 below and a tin halide represented by Structural Formula 3 below, (b) preparing a perovskite precursor solution by heating the mixed solution, and (c) preparing a perovskite composite containing a tin (Sn)-based perovskite and the SbF₃ by drying the perovskite precursor solution and then subjecting the dried perovskite precursor solution to heat treatment.

[Structural Formula 2] A₍₁₋ₐ₎(B_{(1-b)}C_{b})ₐ(X_{(1-c)}Y_{c})₁

[Structural Formula 3] Sn(X_{(1-c)}Y_{c})₂

In Structural Formulas 2 and 3,
A is cesium (Cs),
B and C are different from each other and are each independently methylammonium (MA) or formamidinium (FA),
a is a real number of 0 ≤ a ≤ 1,
b is a real number of 0 ≤ b ≤ 1,
X and Y are different from each other and are each independently fluorine (F), chlorine (Cl), bromine (Br), or iodine (I), and
c is a real number of 0 ≤ c ≤ 1.

Additionally, the tin-based perovskite may be doped with the SbF₃.

Additionally, the perovskite may be represented by Structural Formula 1 below.

[Structural Formula 1] A₍₁₋ₐ₎(B_{(1-b)}C_{b})ₐSn(X_{(1-c)}Y_{c})₃

In Structural Formula 1,
A is cesium (Cs),
B and C are different from each other and are each independently methylammonium (MA) or formamidinium (FA),
a is a real number of 0 ≤ a ≤ 1,
b is a real number of 0 ≤ b ≤ 1,
X and Y are different from each other and are each independently fluorine (F), chlorine (Cl), bromine (Br), or iodine (I), and
c is a real number of 0 ≤ c ≤ 1.

Additionally, the mixed solution may contain 0.01 to 50 mol of the SbF₃, which is preferably in the range of 0.1 to 10 mol and more preferably in the range of 0.1 to 5, based on 100 mol of Sn in the tin halide. When the amount of the SbF₃ is less than 0.01 mol, an effect in hole concentration reduction obtained by containing SbF₃ is insignificant, which is undesirable. When the amount of the SbF₃ exceeds 50 mol, the effect is insignificant compared to the amount of SbF₃ used, which is economically undesirable.

Additionally, the perovskite composite may further contain tin fluoride (SnF₂), and the tin-based perovskite may be co-doped with the SbF₃ and the SnF₂.

Additionally, the mixed solution may contain 0.01 to 50 mol of the SnF₂, which is preferably in the range of 0.1 to 10 mol and more preferably in the range of 0.1 to 5, based on 100 mol of Sn in the tin halide. When the amount of the SnF₂ is less than 0.01 mol, an effect in hole concentration reduction obtained by containing SnF₂ is insignificant, which is undesirable. When the amount of the SnF₂ exceeds 50 mol, phase separation occurs due to the aggregation of SnF₂, which is undesirable.

Additionally, Step (b) may be performed at a temperature in the range of 80°C to 150°C and is preferably performed at a temperature in the range of 90°C to 110°C. When performing Step (b) at a temperature of lower than 80°C, the compounds contained in the mixed solution may fail to be well-mixed, thus deteriorating the performance of the perovskite composite, which is undesirable. When performing Step (b) at a temperature exceeding 150°C, by-products may be formed, which is undesirable.

Additionally, the heat treatment in Step (c) may be performed at a temperature in the range of 100°C to 150°C and is preferably performed at a temperature in the range of 120°C to 140°C. When performing the heat treatment at a temperature of lower than 100°C, SbF₃-doped perovskite may fail to be well-formed, which is undesirable. When performing the heat treatment at a temperature exceeding 150°C, by-products may be formed, which is undesirable.

The present disclosure provides a method of manufacturing a perovskite transistor, the method including the following steps: (1) preparing a gate electrode/insulating layer stack including a gate electrode and an insulating layer disposed on the gate electrode, (2) forming an active layer including a perovskite composite containing a tin (Sn)-based perovskite and antimony trifluoride (SbF₃) on the insulating layer, and (3) forming a source electrode and a drain electrode on the active layer.

### Mode for Invention

### [Examples]

Hereinafter, the present disclosure will be described in more detail with examples. However, these examples are disclosed for illustrative purposes and the scope of the present disclosure is not limited thereby.

### Preparation of perovskite composite

### Example 1: Use of SbF₃ and CsI

### Example 1-1

CsI and SnI₂ were mixed at concentrations of 0.1 M and 5 M, respectively, in a co-solvent of N,N-dimethylformamide (DMF) and dimethyl sulfoxide (DMSO). Then, a mixed solution was prepared such that the amount of antimony trifluoride (SbF₃) was set to 1 mol in the resulting solution based on 100 mol of the total moles of tin ions (Sn²⁺) and antimony.

The resulting mixed solution was heated at a temperature in the range of room temperature to 100°C for 0.1 to 24 hours, thereby preparing a precursor solution.

The precursor solution was dropped on a SiO₂/Si substrate while performing spin coating one to five times at a speed of 0.5 to 9 kilo revolutions per minute (krpm) for 1 to 120 seconds. Next, heat treatment was performed at a temperature in the range of room temperature to 130°C for 1 to 30 minutes, thereby preparing a perovskite composite.

### Examples 1-2 and 1-3

Examples 1-2 and 1-3 were each independently prepared in the same manner as Example 1-1, except that the mixed solution is prepared by varying the concentration of SbF₃ as shown in Table 1 below, instead of preparing the mixed solution so that the concentration of SbF₃ was set to 1 mol%.

### Example 2: Use of SbF₃ and MAI

### Example 2-1

A perovskite composite was prepared in the same manner as Example 1-1, except that MAI was used instead of CsI.

### Examples 2-2 and 2-3

Examples 2-2 and 2-3 were each independently prepared in the same manner as Example 1-1, except that MAI was used instead of CsI, and the mixed solution was prepared by varying the concentration of SbF₃ as shown in Table 1 below, instead of preparing the mixed solution so that the concentration of SbF₃ was set to 1 mol%.

### Example 3: Use of SbF₃ and FAI

### Example 3-1

A perovskite composite was prepared in the same manner as Example 1-1, except for using FAI instead of CsI.

### Examples 3-2 and 3-3

Examples 2-2 and 2-3 were each independently prepared in the same manner as Example 1-1, except that FAI was used instead of CsI, and the mixed solution was prepared by varying the concentration of SbF₃ as shown in Table 1 below, instead of preparing the mixed solution so that the concentration of SbF₃ was set to 1 mol%.

### Example 4: Use of SbF₃ + SnF₂ and CsI

### Example 4-1

Example 4-1 was prepared in the same manner as Example 1-1, except that the mixed solution was prepared by varying the concentrations of SbF₃ and tin fluoride (SnF₂) as shown in Table 1 below, instead of preparing the mixed solution so that the concentration of SbF₃ was set to 1 mol%.

### Comparative Example 1: Use of SnF₂ and CsI

### Comparative Example 1-1

CsI and SnI₂ were mixed at concentrations of 0.1 M and 5 M, respectively, in a co-solvent of DMF and DMSO. Then, a mixed solution was prepared such that the concentration of SnF₂ was set to 1 mol% in the resulting solution based on 100 mol of the total moles of Sn²⁺ and SnF₂.

The resulting mixed solution was heated at a temperature in the range of room temperature to 100°C for 0.1 to 24 hours, thereby preparing a precursor solution.

The precursor solution was dropped on a SiO₂/Si substrate while performing spin coating one to five times at a speed of 0.5 to 9 krpm for 1 to 120 seconds. Next, heat treatment was performed at a temperature in the range of room temperature to 130°C for 1 to 30 minutes, thereby preparing a perovskite composite.

### Comparative Examples 1-2 to 1-4

Comparative Examples 1-2 to 1-4 were each independently prepared in the same manner as Comparative Example 1-1, except that the mixed solution was prepared by varying the concentration of SnF₂ as shown in Table 1 below, instead of preparing the mixed solution so that the concentration of SnF₂ was set to 1 mol%.

**[Table 1]**

| Classification | Halide | SnI₂ (mol%) | SbF₃ (mol%) | SnF₂ (mol%) |
|---|---|---|---|---|
| Example 1-1 | CsI | 99 | 1 | - |
| Example 1-2 | CsI | 98 | 2 | - |
| Example 1-3 | CsI | 96 | 4 | - |
| Example 2-1 | MAI | 99 | 1 | - |
| Example 2-2 | MAI | 98 | 2 | - |
| Example 2-3 | MAI | 96 | 4 | - |
| Example 3-1 | FAI | 99 | 1 | - |
| Example 3-2 | FAI | 98 | 2 | - |
| Example 3-3 | FAI | 96 | 4 | - |
| Example 4-1 | CsI | 91 | 4 | 5 |
| Comparative Example 1-1 | CsI | 95 | - | 5 |
| Comparative Example 1-2 | CsI | 90 | - | 10 |
| Comparative Example 1-3 | CsI | 85 | - | 15 |
| Comparative Example 1-4 | CsI | 100 | - | - |

### Manufacture of transistor

### Device Example 1

FIG. 4A shows a schematic diagram of a perovskite transistor according to one embodiment of the present disclosure. Referring to FIG. 4A, a transistor of Device Example 1 was manufactured.

First, the precursor solution prepared in Example 1 was dropped on SiO₂ of a Si⁺⁺/SiO₂ substrate while performing spin coating one to five times at a speed of 0.5 to 9 krpm for 1 to 120 seconds. Next, heat treatment was performed at a temperature in the range of room temperature to 130°C for 1 to 30 minutes, thereby forming an active layer including the perovskite composite.

An Au electrode was deposited on the active layer, thereby forming a source electrode and a drain electrode.

### Device Examples 2 to 4 and Device Comparative Examples 1 to 4

FIG. 4A shows the schematic diagram of the perovskite transistor according to one embodiment of the present disclosure. Referring to FIG. 4A, transistors of Device Examples 2 and 3 were manufactured.

FIG. 4B shows a schematic diagram of a perovskite transistor including a perovskite composite containing SnF₂ instead of SbF₃ in an active layer. Referring to FIG. 4B, transistors of Device Comparative Examples 1 to 3 were manufactured.

The transistors of Device Examples 2 to 4 and Device Comparative Examples 1 to 4 were manufactured under the same conditions as in Device Example 1 while varying the precursor solution used. The manufacturing conditions are shown in Table 2 below.

**[Table 2]**

| Classification | Perovskite composite | Dopant | |
|---|---|---|---|
| | | SbF₃ (mol%) | SnF₂ (mol%) |
| Device Example 1 | Example 1-1 | 1 | - |
| Device Example 2 | Example 1-2 | 2 | - |
| Device Example 3 | Example 1-3 | 4 | - |
| Device Example 4 | Example 1-4 | 4 | 5 |
| Device Comparative Example 1 | Comparative Example 1-1 | - | 5 |
| Device Comparative Example 2 | Comparative Example 1-2 | - | 10 |
| Device Comparative Example 3 | Comparative Example 1-3 | - | 15 |
| Device Comparative Example 4 | Comparative Example 1-4 | - | - |

### [Test Examples]

### Test Example 1: Confirmation of SbF₃ solubility

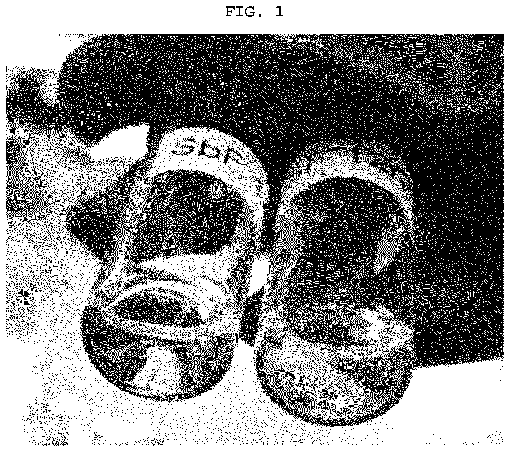

FIG. 1 shows images of the precursor solution (left) prepared in Example 1-3 and the precursor solution (right) prepared in Comparative Example 1-3.

According to FIG. 1, it is confirmed that SbF₃ has higher solubility than SnF₂.

### Test Example 2: Measurement of hole concentration in perovskite composite

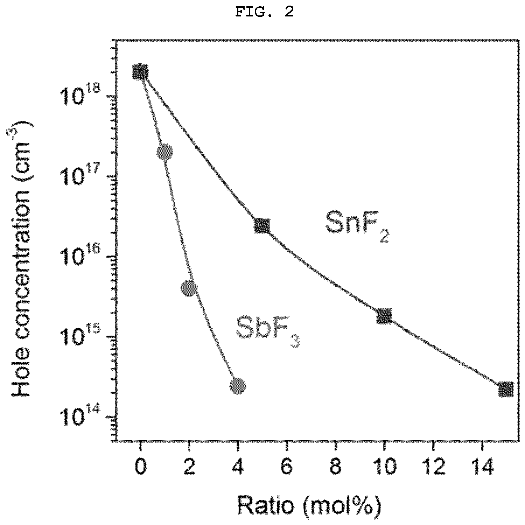

FIG. 2 shows measurement results of hole concentration in the perovskite composites of Examples 1-1 to 1-3 and Comparative Examples 1-1 to 1-4. Specifically, the measurement of hole concentration was performed by the Van der Pauw method using four electrodes.

According to FIG. 2, it is confirmed that the dopant-doped perovskite composites (Examples 1-1 to 1-3 and Comparative Example 1-1 to 1-3) have higher hole-blocking efficiency than the undoped perovskite composite (0 mol%, Comparative Example 1-4), and the SbF₃-doped perovskite composites (Examples 1-1 to 1-3) have much higher hole-blocking efficiency than the SnF₂-doped perovskite composites (Comparative Example 1-1 to 1-3).

Specifically, when compared to the undoped perovskite composite of Comparative Example 1-4 (0 mol%), it is confirmed that the hole concentration in the case of Example 1-3, involving 4 mol% of SbF₃, is enabled to be greatly reduced from 10¹⁸ cm⁻³ to 10¹⁴ cm⁻³. Additionally, when doped with SnF₂, it is confirmed that 15 mol% of SnF₂ is required to be used to make the hole concentration in the perovskite composite 10¹⁴ cm⁻³.

### Test Example 3: Scanning electron microscope (SEM) analysis result performed on perovskite composite

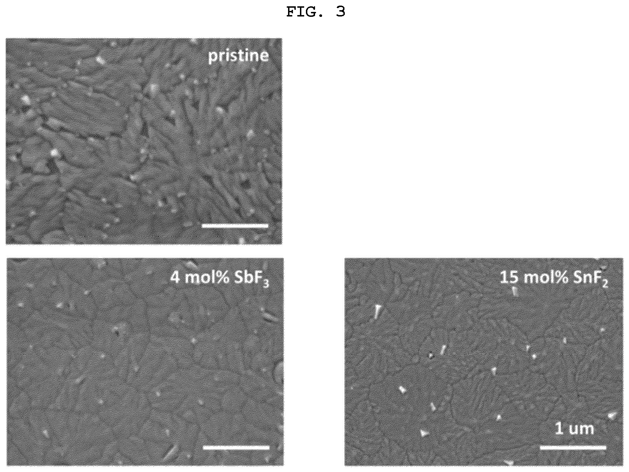

FIG. 3 shows SEM images of the perovskite composites of Example 1-3 and Comparative Examples 1-3 and 1-4.

According to FIG. 3, it is confirmed that the undoped perovskite composite of Comparative Example 1-4 (pristine) fails to form a uniform film, whereas a uniform film is formed in the case of Example 1-3 (4 mol% of SbF₃) and Comparative Example 1-3 (15 mol% of SnF₂) .

Specifically, when co-doped with SbF₃ and SnF₂, it is confirmed that a portion of SnF₂ is precipitated and functions as a heterogeneous nucleation site to promote nucleation and homogeneous growth of perovskite crystals, thus forming a uniform film.

### Test Example 4: Confirmation of characteristics of transistor

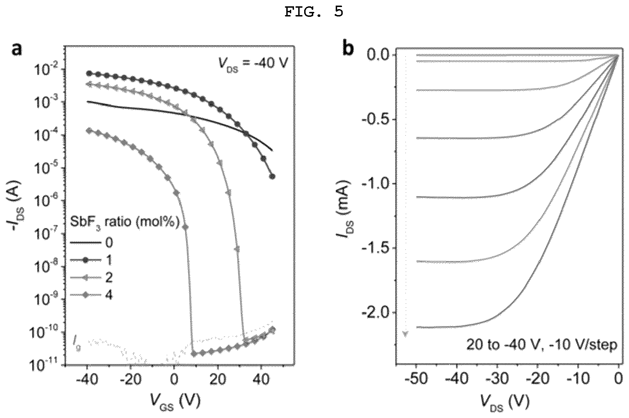

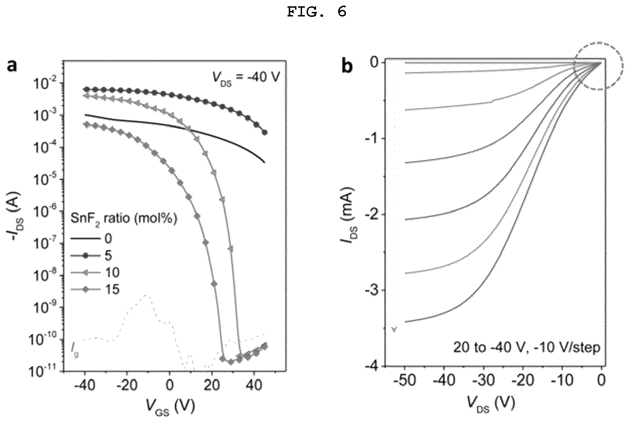

FIG. 5A shows a transfer curve for the perovskite transistors according to Device Examples 1 to 3 and Device Comparative Example 1, FIG. 5B shows an output curve for the perovskite transistor according to Device Example 2, FIG. 6A shows a transfer curve for the perovskite transistors according to Device Comparative Examples 1 to 4, and FIG. 6B shows an output curve for the perovskite transistor according to Device Comparative Example 2.

According to FIGS. 5A and 6A, when the transistor includes the perovskite composite doped with SbF3 or SnF2, the smaller the doping amount, the more similar the performance to that of the existing transistor (0 mol%, Device Comparative Example 4). Additionally, it is confirmed that SbF3 has higher hole-blocking efficiency than SnF2.

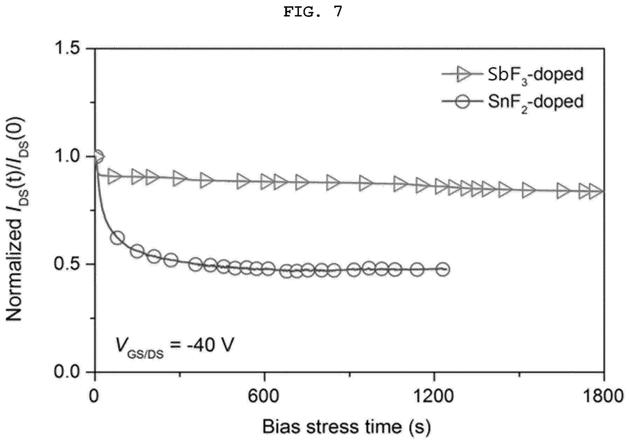

FIG. 7 shows confirmation results of operational stability in Device Example 2 and Device Comparative Example 2.

According to FIGS. 5B, 6B, and 7, it is confirmed that phase separation of the SbF₃-doped perovskite composite from the active layer occurs less due to the excellent solubility of SbF₃ confirmed in Test Example 1 above, thus obtaining better contact properties and higher operational stability.

### Test Example 5: Confirmation of co-doping effect with SbF₃ + SnF₂

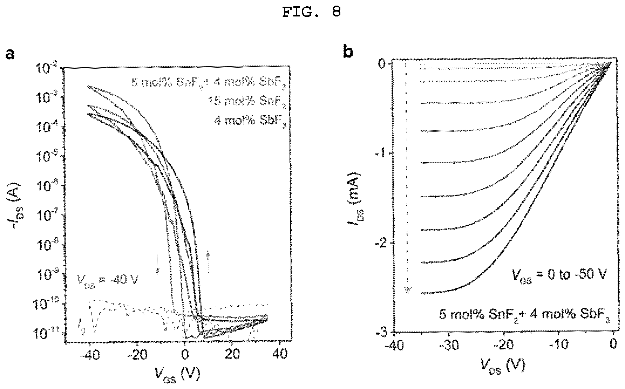

FIG. 8A shows a transfer curve for the perovskite transistors according to Device Examples 3 and 4 and Device Comparative Example 3, and FIG. 8B shows an output curve for the perovskite transistor according to Device Example 4.

According to 8A, it is confirmed that the perovskite transistor (5 mol% of SnF₂ + 4 mol% of SbF₃), according to Device Example 4, exhibits a small subthreshold swing (SS) of 0.5 V/dec and an ideal V_{ON} of about 0 V. A minimum gate voltage is required to turn the transistor on and off, so the V_{ON} of 0 V is significantly preferable for low-power consumption applications. SS is a measure of how efficiently a transistor can turn on and off, which is directly related to the electronic quality of the channel/dielectric interface. It is confirmed that the SS value in the case of Device Example 4 is much lower than that (≒ 5 V/dec) in the case of existing p-channel metal halide/oxide transistors with silicon oxide and is similar to that (≒ 0.5 V/dec) of n-channel metal-oxide transistors, such as indium gallium zinc oxide (IGZO) thin film transistor.

According to FIG. 8B, it is confirmed that the output curve for the perovskite transistor (5 mol% of SnF₂ + 4 mol% of SbF₃), according to Device Example 4, shows good current formation at low V_{DS} and current saturation at high V_{DS}.

The results of FIGS. 8A and 8B show that co-doping with SbF₃/SnF₂ enables a Sn-based perovskite semiconductor layer with high mobility and on/off current ratio and a transistor including the same to be manufactured.

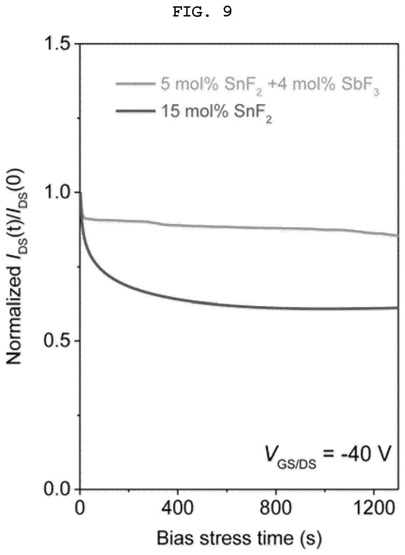

FIG. 9 shows confirmation results of operational stability in Device Example 4 and Device Comparative Example 3.

According to FIG. 9, it is confirmed that the operational stability of the device is higher in the case of Device Example 4 (5 mol% of SnF₂ + 4 mol% of SbF₃) co-doped with SnF₂ and SbF₃ than in the case of Device Comparative Example 3 (15 mol% of SnF₂) doped with SnF₂ alone.

The scope of the present disclosure is defined by the appended claims rather than the detailed description presented above. All changes or modifications derived from the meaning and scope of the claims and the concept of equivalents should be construed to fall within the scope of the present disclosure.

### Industrial Applicability

A perovskite composite of the present disclosure is lead (Pb)-free by containing a tin (Sn)-based perovskite and antimony trifluoride (SbF₃), has a low hole concentration (≤ 10¹⁴ cm⁻¹), and thus can be used for an optoelectronic device.

Additionally, a perovskite transistor of the present disclosure includes the perovskite composite and thus can be highly stable.

## Claims

1. A perovskite composite comprising:
a tin (Sn)-based perovskite; and
antimony trifluoride (SbF₃).

2. The perovskite composite of claim 1, wherein the Sn-based perovskite is doped with the SbF₃.

3. The perovskite composite of claim 1, wherein the Sn-based perovskite is represented by Structural Formula 1,
[Structural Formula 1] A₍₁₋ₐ₎(B_{(1-b)}C_{b})ₐSn(X_{(1-c)}Y_{c})₃
where in Structural Formula 1,
A is cesium (Cs),
B and C are different from each other and are each independently methylammonium (MA) or formamidinium (FA),
a is a real number of 0 ≤ a ≤ 1,
b is a real number of 0 ≤ b ≤ 1,
X and Y are different from each other and are each independently fluorine (F), chlorine (Cl), bromine (Br), or iodine (I), and
c is a real number of 0 ≤ c ≤ 1.

4. The perovskite composite of claim 1, wherein the perovskite composite comprises 0.01 to 50 mol of the SbF₃ based on 100 mol of the Sn-based perovskite.

5. The perovskite composite of claim 1, further comprising tin fluoride (SnF₂), wherein the Sn-based perovskite is co-doped

6. The perovskite composite of claim 1, wherein the perovskite composite comprises 0.01 to 50 mol of the SnF₂ based on 100 mol of the Sn-based perovskite.

7. Any one electronic element selected from the group consisting of a transistor, a solar cell, a light-emitting diode, a photodiode, and a photosensor, the electronic element comprising the perovskite composite of claim 1.

8. A perovskite transistor comprising:
a gate electrode;
an insulating layer disposed on the gate electrode;
an active layer disposed on the insulating layer, the active layer comprising a perovskite composite comprising a tin (Sn)-based perovskite and antimony trifluoride (SbF₃); and
a source electrode and a drain electrode spaced from each other while being disposed on the active layer.

9. The perovskite transistor of claim 8, wherein the Sn-based perovskite is doped with the SbF₃.

10. The perovskite transistor of claim 8, wherein the perovskite composite further comprises tin fluoride (SnF₂), and the Sn-based perovskite is co-doped with the SbF₃ and the SnF₂.

11. The perovskite transistor of claim 8, wherein the gate electrode comprises one or more selected from the group consisting of n-doped silicon (Si), p-doped Si, gold (Au), silver (Ag), platinum (Pt), titanium (Ti), Aluminum (Al), tungsten (W), magnesium (Mg), calcium (Ca), ytterbium (Yb), chromium (Cr), nickel (Ni), gold oxide, platinum oxide, silver oxide, palladium oxide, iron oxide, graphene, a carbon nanotube (CNT), an Ag nanowire (NW), indium tin oxide, and poly(3,4-ethylenedioxythiophene) polystyrene sulfonate (PEDOT:PSS), and
the source electrode and the drain electrode each independently comprise one or more selected from the group consisting of Au, Ag, Pt, Ti, Al, W, Mg, Ca, Yb, Cr, Ni, gold oxide, platinum oxide, silver oxide, palladium oxide, iron oxide, graphene, a CNT, an Ag NW, indium tin oxide, and PEDOT:PSS.

12. The perovskite transistor of claim 8, wherein the insulating layer comprises one or more selected from the group consisting of silicon dioxide, glass, quartz, alumina, silicon carbide, magnesium oxide, polyethylene naphthalate (PEN), polyethylene terephthalate (PET), polystyrene (PS), polyimide (PI), polyvinyl chloride (PVC), polyvinylpyrrolidone (PVP), polyethylene (PE), silicon oxide (SiO₂), germanium, polyvinyl alcohol (PVA), polymethyl methacrylate (PMMA), zirconium oxide (ZrO₂), aluminum oxide (AlO₂), and hafnium oxide (HfO₂) .

13. A method of preparing a perovskite composite, the method comprising:
(a) preparing a mixed solution by mixing antimony trifluoride (SbF₃) in a solution comprising a compound represented by Structural Formula 2 and a tin halide represented by Structural Formula 3;
(b) preparing a perovskite precursor solution by heating the mixed solution; and
(c) preparing a perovskite composite comprising a tin (Sn) - based perovskite and the SbF₃ by drying the perovskite precursor solution and then subjecting the dried perovskite precursor solution to heat treatment,
[Structural Formula 2] A₍₁₋ₐ₎(B_{(1-b)}C_{b})ₐ(X_{(1-c)}Y_{c})₁
[Structural Formula 3] Sn (X_{(1-c)}Y_{c})₂
where in Structural Formulas 2 and 3,
A is cesium (Cs),
B and C are different from each other and are each independently methylammonium (MA) or formamidinium (FA),
a is a real number of 0 ≤ a ≤ 1,
b is a real number of 0 ≤ b ≤ 1,
X and Y are different from each other and are each independently fluorine (F), chlorine (Cl), bromine (Br), or iodine (I), and
c is a real number of 0 ≤ c ≤ 1.

14. The method of claim 13, wherein the Sn-based perovskite is doped with the SbF₃.

15. The method of claim 13, wherein the mixed solution comprises 0.01 to 50 mol of the SbF₃ based on 100 mol of the Sn in the tin halide.

16. The method of claim 13, wherein the perovskite composite further comprises tin fluoride (SnF₂), and the Sn-based perovskite is co-doped with the SbF₃ and the SnF₂.

17. The method of claim 16, wherein the mixed solution comprises 0.01 to 50 mol of the SnF₂ based on 100 mol of the Sn in the tin halide.

18. The method of claim 13, wherein the (b) preparing is performed at a temperature in a range of 80°C to 150°C.

19. The method of claim 13, wherein the heat treatment in the (c) preparing is performed at a temperature in a range of 100°C to 150°C.

20. A method of manufacturing a perovskite transistor, the method comprising:
(1) preparing a gate electrode/insulating layer stack comprising a gate electrode and an insulating layer disposed on the gate electrode;
(2) forming an active layer comprising a perovskite composite comprising a tin (Sn)-based perovskite and antimony trifluoride (SbF₃) on the insulating layer; and
(3) forming a source electrode and a drain electrode on the active layer.
